# EUROPEAN PATENT SPECIFICATION

(11) **EP 1 912 121 B1**
(45) Date of publication and mention of the grant of the patent: **12.08.2009**
(21) Application number: 06425632.4
(22) Date of filing: 13.09.2006
(51) Int. Cl.: G06F 11/10, G06F 11/20

(54) **NAND flash memory device with ECC protected reserved area for non volatile storage of redundancy data**
NAND-Flash-Speichervorrichtung mit ECC-geschütztem reserviertem Bereich für nicht-flüchtige Speicherung von Redundanzdaten
Dispositif de mémoire flash non-et avec zone réservée protégée ECC pour le stockage non-volatile de données redondantes

(43) Date of publication of application: 16.04.2008
(73) Proprietor: STMicroelectronics S.r.l., 20041 Agrate Brianza MI (IT); Hynix Semiconductor Inc., Ichon-si, Kyoungki-do 467-701 (KR)
(72) Inventor: Micheloni, Rino, 22078 Turate (IT); Ravasio, Roberto, 24036 Ponte San Pietro (IT); Marelli, Alessia, 24044 Dalmine (IT)
(74) Representative: Kraus, Jürgen Helmut

(56) References cited:
- EP-A- 1 607 865
- US-A1- 2003 206 460

## Description

### BACKGROUND

### Field of the Invention

The present invention relates to memory devices and more particularly to a NAND flash memory device with an area efficient redundancy architecture.

### Discussion of prior art

In NAND type memory devices, device specific self configuration data and redundancy data of identified fail elements of the array of memory cells and of attributed substitute elements address in the redundant resource area of the array is commonly stored in a non volatile manner in dedicated fuse arrays that are permanently set during the testing on wafer (EWS) phase of the devices of the fabrication process.

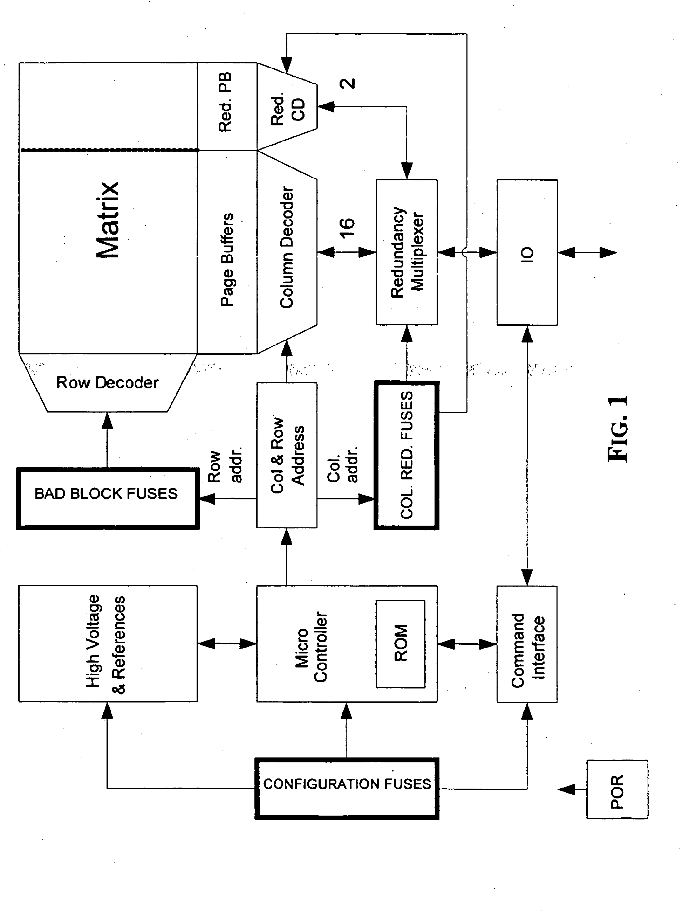

Figure 1 is a simplified high level block diagram of a common NAND flash memory device, in which the fuse arrays containing the basic data of redundancy and self configuration implementation at every power-on of the device are placed in evidence by tracing the relative blocks with a heavier line, namely: the *CONFIGURATION FUSE* block for setting important electrical operating parameters such as voltage levels and voltage references at every power-on of the device, according to common practices in the art; the *BAD BLOCK FUSE* array containing the locating data blocks of addressable of memory cells of the user addressable area (MATRIX) of the memory cell array found to contain fail element during the EWS testing phase and the *COLUMN REDUNDANCY FUSE* array for re-directing the access to a fail memory location to substitute column of cells of a redundancy area of the memory cell array. Commonly, the addressable area (MATRIX) of the memory cell array and the redundancy resource area are provided with distinct page buffers associated to respective column decoder circuits.

The scheme of figure 1, can be immediately read by any skilled person and a punctual description of the other architectural component shown in the scheme is deemed unnecessary for the comprehension of the technical problems and of the solution found by the applicant.

The number of redundancy resources to be utilized in fabricated devices obviously increases with increasing storage capacity of the memory devices.

Unfortunately, the size of the fuses does not decrease as quickly as the size and compactness degree of cell arrays and this fact negatively reflects on the relative area ratio.

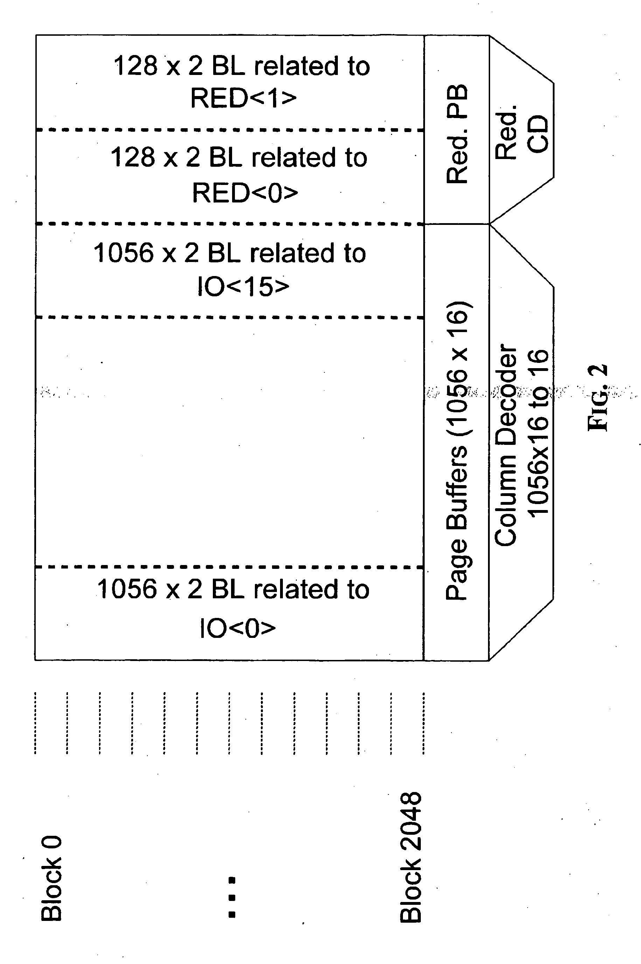

Figure 2 shows a common representation of the arrangement of blocks of memory cells of the addressable area of the array and of fail bit lines, emphasizing the integrated structures that require dedicated fuses for implementing the substitution of fail elements with equivalent redundant resources.

Possible alternatives to the implementation of an excessively large number of fuses to be set during EWS phase could in principle be to non volatily storing the basic redundancy data in either dedicated non volatile supports such as the so-called UPROM-like structures or in a so-called one time programmable (OTP-like) arrays of cells belonging to a dedicated sector of the cell array.

The UPROM option implies the use of a dedicated memory array purposely integrated in the device having a read circuitry that is practically distinct from the read circuitry of the NAND flash memory array. The dedicated UPROM memory array must be specially designed to have a sufficiently enhanced reliability in order to generate a very high flawless probability. However such a solution, beside an intrinsically large area requirement, is technologically hardly applicable in the context of modern NAND type flash memory device fabrication processes.

The other option contemplating the use of a portion or block or dedicated area of the flash memory cell array as a "one time programmable" memory block, though apparently promising for non volatily storing redundancy as well as self configuration data, has not found application because, in the case of NAND flash memory devices, its implementation is hindered by remarkable problems descending from the two following conditions:
a) in NAND type flash memory devices, differently from other types of flash memories, a gerarchic organization of the cell array is not implemented because it would be too burdensome in terms of silicon area requirement and, as a consequence, the cell array bitlines are common to all blocks of cells;
b) all blocks of a certain number of word lines of array cells are commonly formed in a N-type and in a P-type tubs formed in a P-type silicon substrate and therefore the blocks of cells may hardly be electrically isolated from one another.

Differently from common user's OTP(s) that are eventually accessed only after the substitution of fail elements with redundant resources has already been implemented following the conclusion of the power-on phase, the first condition (a) implies that any fail bitline to be eventually substituted by the redundancy architecture would still be read at power-on of the memory device, thus corrupting basic any redundancy data that could be stored in a reserved area of the memory array.

The second condition (b) implies any such one time programmable reserved area would of course be subject to all the electrical stresses consequent to all erasing operations carried out in any of the blocks of cells of the area of the array addressable by the external user of the device, for the whole operating life of the device itself, and therefore the correct reading of redundancy data from a reserved area at power-on may, in time, become more and more critical.

US 2003/0206460 A1 refers to a storage device counting error correction. To this end, a semiconductor storage device determines the cause of an error at the time of the error correction of data read out from a non volatile semiconductor memory, on the basis of a previously recorded error correction count, and selects a data refresh processing or a substitute processing to perform. When the error is detected, the corrected data is rewritten back for preventing reoccurrence of errors due to accidental cause. While, when it is determined that the reoccurrence frequency of the error is high and the error is due to degradation of the storage medium, based on the error correction count, the substitute processing is performed.

EP 1 607 865 A1 refers to a boot method for a data control unit, wherein boot information is downloaded from a non volatile memory into a temporary buffer of a boot-activation unit; a processing unit is activated by the boot-activation unit; a boot code is executed by the processing unit; and an operating code is downloaded from the non volatile memory into a volatile memory through the boot-activation unit. To correct possible errors in the block of the non volatile memory containing information and boot codes, the boot-activation unit verifies whether the boot information downloaded into its volatile memory has a critical-error condition and activates a spare memory portion of the non volatile memory in presence of the critical-error condition.

### SUMMARY OF THE INVENTION

The applicants have found an effective solution to the above-noted incompatibilities and restraints of the art that achieves the objective of significantly reducing silicon area requirement of a non volatile page mode memory device while achieving significantly enhanced fabrication yields without significantly compromising the operating life characteristics of the devices.

According to this invention, the basic redundancy information is non volatily stored in a reserved area (that is an area of the array that is not addressable by the user of the device) of the addressable area of the array and is copied on volatile storage supports at every power-on of the memory device.

The unpredictable though statistically inevitable presence of fail array elements also in such a reserved area of the memory array that would corrupt the basic redundancy information as established during the test-on wafer (EWS) phase of the fabrication process and thus increasing the number of rejects, lowering the yield of the fabrication process, has being found to be effectively overcome by writing the basic redundancy data in the reserved area of the array with an ECC technique, using a certain error correction code that may be chosen among so-called majority codes 3, 5, 7, 15 and the like or Hamming code for 1, 2, 3 or more errors, in function of the fail probability of a memory cell as determined by the testing on wafer of the devices during fabrication (fail probability of the specific fabrication process used).

In other words, through an appropriate screening of the EWS test results it is ensured that the corrective power of the selected ECC technique is appropriate to handle the fail density in the reserved area.

This, eventually coupled in the case of a multilevel flash memory, with the utilization of the two extreme distributions of the multilevel memory for writing the ECC protected data in the reserved area and with a single level mode reading of the data, at power-on with relatively relaxed read parameters (time intervals, voltages), has proven to comfortably prevent any negative influence on the process yield imputable to the storing of the basic redundancy data in the non volatile memory device array itself.

The so permanently stored basic redundancy data are read and decoded by an appropriate logic circuit at every power-on of the memory device and relevant redundancy information is copied in one or more preferably in two distinct volatile memory supports that become part of the redirecting circuit of user access to fail memory array locations to substitute memory array elements in the redundancy area of the cell array during normal operation of the device, following the conclusion of the power-on phase.

Besides basic redundancy data, even certain self configuring data and program codes to be executed by the microcontroller for carrying out the memory operations as commanded by the external user, may be advantageously stored in the reserved area of the memory array, writing and reading with the same ECC technique and relaxed read conditions similarly to the basic redundancy data.

The invention is defined in annexed independent claims 1 and 8.

### BRIEF DESCRIPTION OF THE DRAWINGS

**Figure 1** and **Figure 2** are as already discussed, a high level functional block diagram of a non volatile page mode memory device having a known architecture and a representation of the blocks and words arrangements in the addressable area and in the redundancy area of a NAND memory cell array.
**Figure 3** is a representation of an equivalent NAND memory cell array with graphical indication of fail array elements and of a reserved area according to this invention.
**Figure 4** is a high level functional block diagram of a non volatile page mode memory device with the modified architecture according to this invention.
**Figure 5** shows a fail graph of these error correction codes in function of the fail probability of a memory cell.

### DESCRIPTION OF EMBODIMENTS OF THE INVENTION

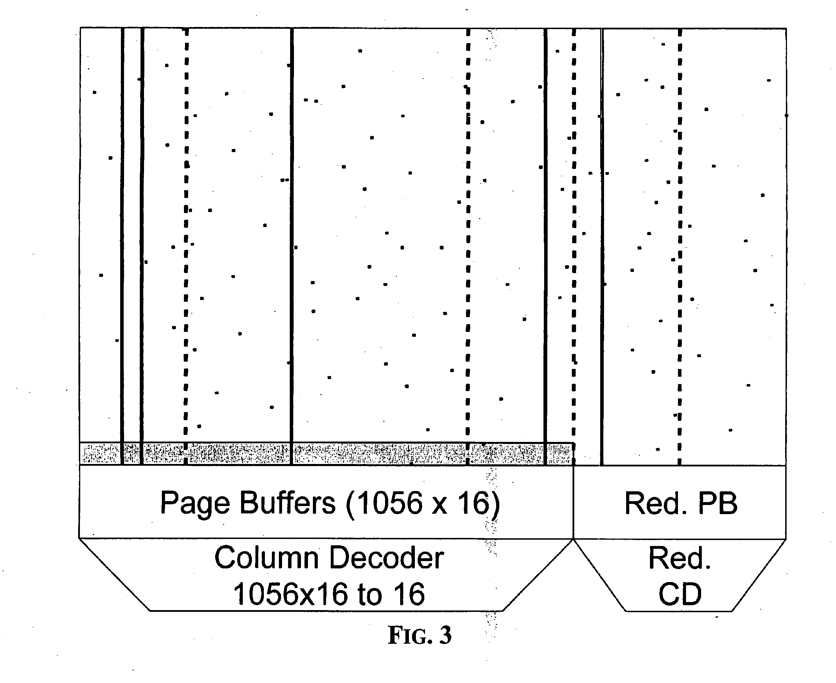

As graphically represented in Figure 3, a reserved area RA (identified by the darkened field) that will not be addressable by the user of the EWS-tested, trimmed, repaired and finally finished memory device, is part of the addressable area of the memory cell array, that practically may retain the same organization graphically defined in Figure 2.

In Figure 3, the dark dots indicate fail cell(s) that cannot be utilized (as identified during the test-on wafer of the device) and the solid vertical lines represent fail bit lines of the array (as also identified during the test-on wafer phase).

The basic redundancy data on the fail array elements identified during the EWS testing are written, during the EWS phase itself, in the reserved area RA of the addressable area of the memory cell array, identified by the darkened array area in Figure 3.

The writing of the basic redundancy data in the reserved area is made with an ECC data writing technique according to a certain error correction code.

Moreover, the writing of the basic redundancy data in the reserved area of the addressable memory array is carried out in a way to ensure enhanced read margins for example, in case of a multilevel memory device, by using the extreme threshold voltage distributions for thereafter reading the so written information in a single level read mode and preferably with all electrical parameters pertinent to the reading of the recorded data (read voltage levels and time intervals) relatively relaxed in order to ensure a large margin of discrimination of the recorded information.

According to this invention, the redundancy system of the memory device permits the reading of the basic redundancy data from the reserved area at power-on without the assistance of any information contained in the reserved area itself.

Of course, at power-on, in consideration of the fact that the column redundancy information is not yet present in the volatile storage means of the circuit that implements the substitution of fail bitlines, such a re-directing function remains disabled during the early part of the power-on phase.

The following is a selection of ECC codes that may be appropriate for a modern NAND memory device fabrication process:

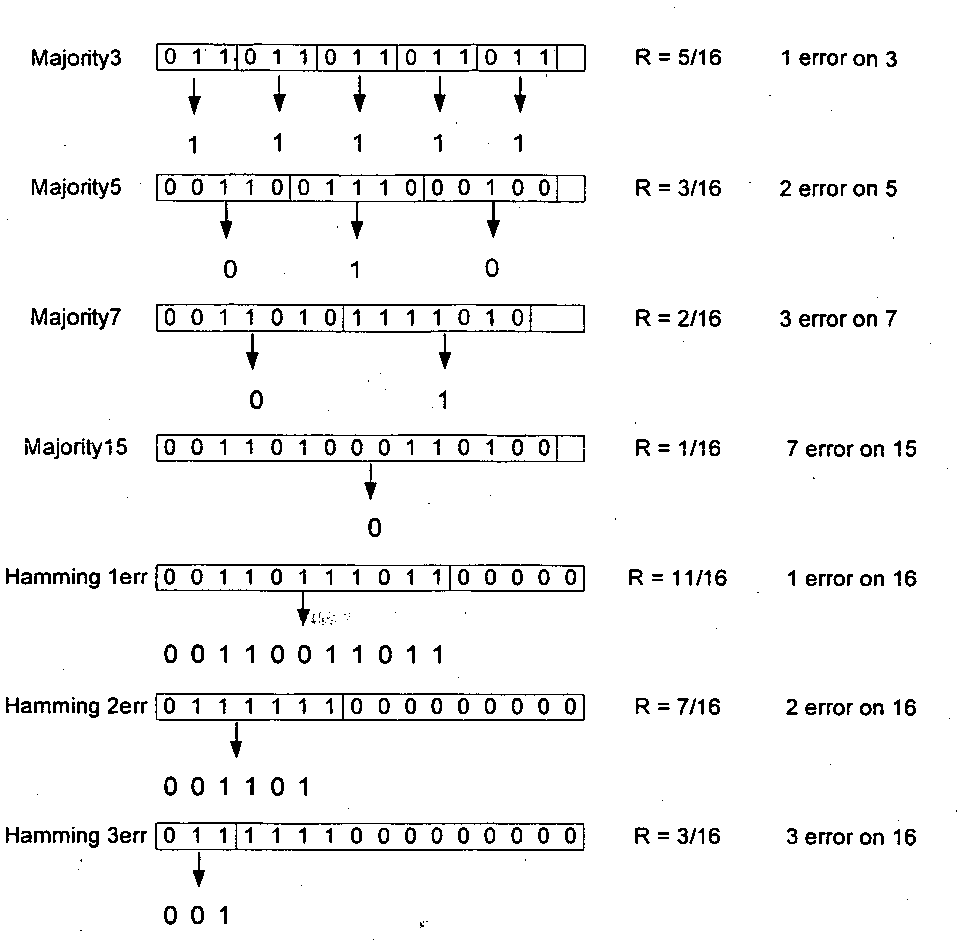

The choice of the ECC code generally will depend on the number of parity bits required, circuital complexity, correction power of the ECC technique and on the fail probability of a fabricated memory cell.

For example, by supposing to be required of effectively ECC protecting 6144 bits of basic information to be written on the reserved area RA of the memory array, depending on the choice of the different codes indicated above, the reserved area will need to have a capacity as specified herein below.

Majority 3 Each bit is written three times thus allowing correction of one error every three bits. In practice there will be five effective bits of information for each word. This coding scheme requires a total number of 18432 bits and implies a very small computational complexity.

Majority 5 Each bit is written five times thus permitting correction of two errors every 5 bits. Three effective bits of information are present in each word. This coding scheme requires a total of 30720 bits with a very small computational complexity.

Majority 7 Each bit is written seven times thus permitting to correct three errors every seven bits. There are two effective information bits in each word. The coding scheme requires a total of 43008 bits with a very small computational complexity.

Majority 15 Each bit is written fifteen times thus permitting to correct seven errors every five bits, in each work there will be only one effective information bit. The coding scheme will require a total of 92160 bits with a very small computational complexity.

Hamming 1err This scheme is based on a Hamming code capable of correcting one error every fifteen bits. Each word contains eleven bits of information. The scheme requires a total of 8385 bits and implies a moderate computational complexity.

Hamming 2err This scheme is based on a matrix Hamming code (extended Hamming code) capable of correcting two errors every fifteen bits. Each word contains seven bits of information. The scheme requires a total 13170 bits and a substantial computational complexity for implementing a decoding matrix that must be capable of considering all syndromes that may occur in presence of one or two errors.

Hamming 3err This scheme is based on an extended matrix Hamming code capable of correcting three errors every 15 bits. Each word contains 3 bits of information. This scheme requires a total of 30720 bits with a rather complex computational circuital burden.

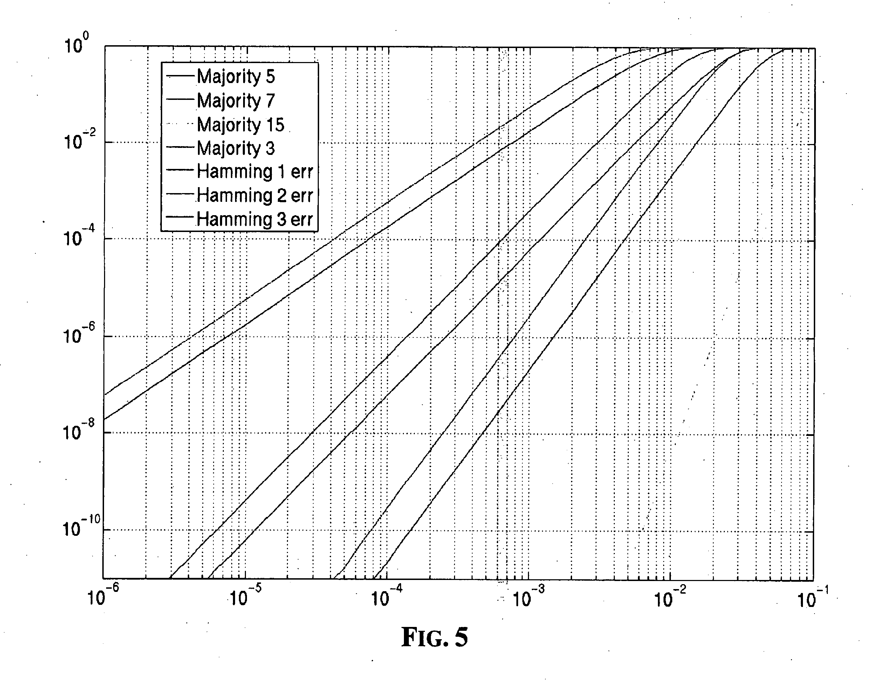

For the example considered, Figure 5 is a graphical representation of the fail characteristics of the above specified codes in function of the fail probability of a fabricated cell. By assuming that the ratio of fail probabilities and of the bits lines of the cells be equal to 10⁻³, it may be observed that the ECC codes with a correction power of only one error would be unsatisfactory because they would lead to an excessively high fail probability. By contrast, the ECC correction code with a correction power of seven errors is excessive, taking into consideration the number of bits it requires.

For the considered example, the most appropriate ECC codes appears to be those with a correction power of two or three errors and the ultimate choice will depend on the preferred compromise between the total number of bits required (that is definitely larger for the majority codes) and the associated computational circuit complexity.

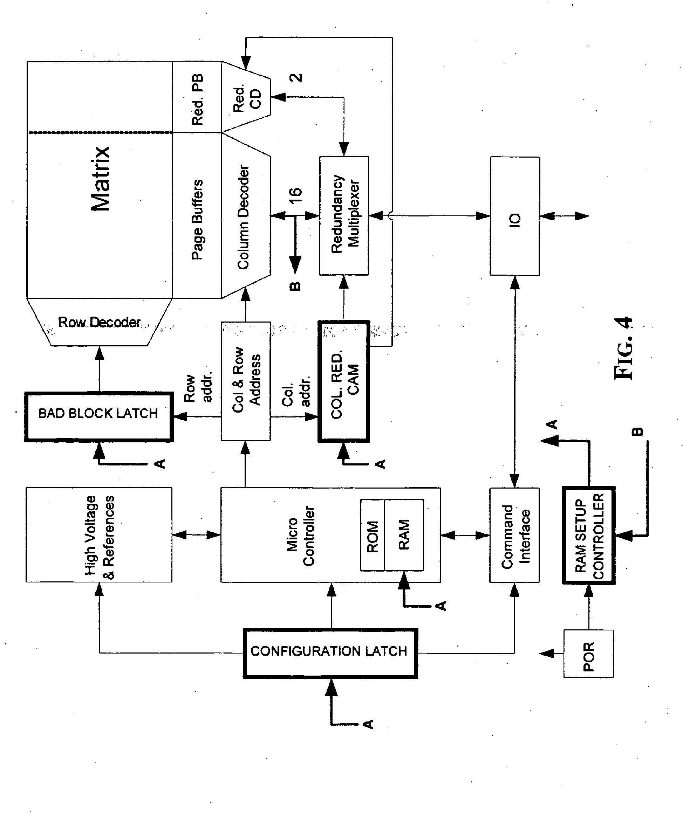

A sample block diagram of a non volatile page mode NAND memory device of this invention is shown in Figure 4.

The characterizing features of the novel device of this invention are emphasized by the blocks drawn with thicker solid lines, for a more immediate comparison with the functional block diagram of the prior art device of Figure 1.

According to this invention, immediately, after the power-on reset phase, the basic redundancy information non volatily stored in the reserved area RA of the array (matrix) is read through the read circuitry of the memory device and a controller circuit RAM SET UP CONTROLLER copies the bad block addresses in a volatile buffer BAD BLOCK RAM buffer that is directly interfaced with the microcontroller of the memory device.

Moreover, the RAM SET UP CONTROLLER block sets a CAM (content addressed memory) array CALL.RED.CAM.

Optionally, as shown in the sample device architecture of Figure 4, besides the basic redundancy data, the reserved area RA of the memory array, may store specific configuration data of the device, for example trim voltage and timing interval values, as defined for the fabrication memory device during the EWS phase. These configuring data are similarly read immediately after the power-on reset phase and copied by the block RAM SET UP CONTROLLER in the block of CONFIGURATION LATCHES, for trimming the high voltage and voltage reference generator block. Other configuration data to be thereafter accessed by the microcontroller in executing the power-on configuration programs may also be so copied on the volatile support immediately after the power-on reset phase.

Upon terminating the power-on phase, the device will be ready to operate, the volatile redundancy data storing blocks, namely the BAD BLOCK RAM and the CALL.READ.CAM block becoming part of the circuit that carries out the redundancy substitution of fail array elements at every power-on of the device.

## Claims

1. A non volatile page mode memory device comprising an array of rows and columns of memory cells including an addressable area and a redundancy area, the device including circuit means to support fail memory location data of said addressable area for re-directing toward substitute memory array elements in said redundancy area, **characterized in that** said circuit means comprise:
at least a reserved area (RA), not addressable by a user of the device, of said addressable area of the array in which are stored said fail memory location data with an error protected data writing technique according to an error correction code selected to provide adequate error correction power for fail probabilities of the memory cells and array bit lines established during a test-on-wafer phase;
a logic circuit for decoding the fail memory location data according to the error correction code used in writing them;
at least first volatile memory (BAD BLOCK RAM) for fail blocks of said addressable area and second volatile memory (CALL.READ.CAM) for fail bitlines of said addressable area, in which decoded fail memory location data read from said reserved area at power-on is copied.

2. The non volatile page mode memory device of claim 1, wherein said first volatile memory (BAD BLOCK RAM) for fail blocks include a RAM buffer interfaced to said microcontroller.

3. The non volatile page mode memory device of claim 1, wherein said second volatile memory (CALL.READ.CAM) for fail bitlines include a CAM array, stimulated by column and row addresses generated by said microcontroller, for redirecting user access to substitute bitlines of said redundancy area.

4. The non volatile page mode memory device of claim 1, wherein in said reserved area (RA) of the addressable area of the array are written with the same error protected data writing technique according to said error correction code also data of self configuration of the memory device used in execution of a self configuring program code executed by said microcontroller at every power-on of the device and the device comprises a latch array in which said data of self configuration read from said reserved area are copied at every power-on of the device.

5. The non volatile page mode memory device of claim 1, wherein data are written in format of words composed by sixteen bits and said error correction code is chosen from the group composed of majority code 3, 5, 7, 15, Hamming code for 1, 2 and 3 errors, depending on a fail probability of a memory cell as determined by testing on wafer the fabricated devices.

6. The non volatile page mode memory device of claim 1, wherein said data are read from said reserved area (RA) of the array in a single level mode.

7. The non volatile page mode memory device of claim 1, wherein with the exception of boot-up program codes any other program code to be executed by the microcontroller is stored in a non-volatile manner in said reserved area (RA) of the addressable area of the array, the program codes residing therein being also copied in a RAM buffer at every power-on of the device.

8. A method of substituting fail array elements of a non volatile page mode memory device comprising an array of rows and columns of memory cells divided in an addressable area and a redundancy area, the method **characterized by** the steps of
establishing during a test-on-wafer phase a fail probability of a fabricated cell and of array bit lines;
selecting an error correction code for writing data of adequate error correction power for the assessed fail probabilities;
reserving an area (RA) of said addressable area of the memory array, not addressable by the user of the memory device, of storage capacity adequate to store fail memory location data as established during said test-on-wafer of the fabricated device, by writing therein the fail memory location data according to said selected error correction code;
reading and decoding the fail memory location data from said reserved area at every power-on of the device;
copying fail block data of said reserved area of the array in first volatile memory (BAD BLOCK RAM) and fail bit line data of said addressable area in second volatile memory (CALL.READ.CAM); and
accessing said first volatile memory and said second volatile memory to re-direct, toward substitute memory array elements, any external user access to said fail memory locations.

9. The method of claim 8, further comprising:
writing, with the selected error correction code, data of self configuration of the memory device to the reserved area.

10. The method of claim 8, wherein the selecting comprises:
selecting the error correction code from the group composed of majority code 3, 5, 7, 15, Hamming code for 1, 2 and 3 errors.

11. The method of claim 8, wherein the first volatile memory (BAD BLOCK RAM) is configured as a RAM buffer interfacing with a microcontroller of the device.

12. The method of claim 8, wherein the second volatile memory (CALL.READ.CAM) is configured as a content addressed memory array stimulated by column and row addresses generated by a microcontroller of the device.

13. The method of claim 8, wherein said reading the fail memory location data comprises is based on a single-level mode.

## Patentansprüche

1. Nichtflüchtige Page-Modus-Speichervorrichtung, umfassend einen Array aus Zeilen und Spalten von Speicherzellen, der einen adressierbaren Bereich und einen Redundanzbereich beinhaltet, wobei die Vorrichtung eine Schaltungseinrichtung beinhaltet, um Ausfallspeicherortsdaten des adressierbaren Bereichs zu unterstützen zwecks Umleitens zu Ersatzspeicherarrayelementen im Redundanzbereich, **dadurch gekennzeichnet, dass** die Schaltungseinrichtung umfasst:
zumindest einen reservierten, durch einen Benutzer der Vorrichtung nicht adressierbaren, Bereich (RA) des adressierbaren Bereichs des Arrays, in dem die Ausfallspeicherortsdaten mit einer Fehlerschutz-Datenschreibtechnik in Übereinstimmung mit einem Fehlerkorrekturcode gespeichert werden, der ausgewählt ist, um eine adäquate Fehlerkorrekturleistung für während einer Phase des Testens auf Wafer ermittelte Ausfallwahrscheinlichkeiten der Speicherzellen und Arraybitleitungen zu erbringen;
eine Logikschaltung zum Decodieren der Ausfallspeicherortsdaten in Übereinstimmung mit dem beim Schreiben derselben verwendeten Fehlerkorrekturcode;
zumindest einen ersten flüchtigen Speicher (BAD BLOCK RAM) für Ausfallblöcke des adressierbaren Bereichs und einen zweiten flüchtigen Speicher (CALL.READ.CAM) für Ausfallbitleitungen des adressierbaren Bereichs, in welche aus dem reservierten Bereich beim Einschalten gelesene, decodierte Ausfallspeicherortsdaten kopiert werden.

2. Nichtflüchtige Page-Modus-Speichervorrichtung nach Anspruch 1, wobei der erste flüchtige Speicher (BAD BLOCK RAM) für Ausfallblöcke einen RAM-Puffer beinhaltet, der über eine Schnittstelle mit dem Mikrocontroller verbunden ist.

3. Nichtflüchtige Page-Modus-Speichervorrichtung nach Anspruch 1, wobei der zweite flüchtige Speicher (CALL.READ.CAM) für Ausfallbitleitungen einen CAM-Array, angesprochen durch vom Mikrocontroller erzeugte Spalten- und Zeilenadressen, zum Umleiten von Benutzerzugriff auf Ersatzbitleitungen des Redundanzbereichs beinhaltet.

4. Nichtflüchtige Page-Modus-Speichervorrichtung nach Anspruch 1, wobei in den reservierten Bereich (RA) des adressierbaren Bereichs des Arrays, mit der gleichen Fehlerschutz-Datenschreibtechnik in Übereinstimmung mit dem Fehlerkorrekturcode, weiterhin Daten zur Selbstkonfiguration der Speichervorrichtung geschrieben werden, die bei Ausführung eines selbstkonfigurierenden Programmcodes verwendet werden, der vom Mikrocontroller bei jedem Einschalten der Vorrichtung ausgeführt wird, und die Vorrichtung einen Latcharray umfasst, in welchen aus dem reservierten Bereich gelesene Daten zur Selbstkonfiguration bei jedem Einschalten der Vorrichtung kopiert werden.

5. Nichtflüchtige Page-Modus-Speichervorrichtung nach Anspruch 1, wobei Daten im Format von Worten, die sich aus sechzehn Bits zusammensetzen, geschrieben werden und der Fehlerkorrekturcode aus der Gruppe, die aus Mehrheitscode 3, 5, 7, 15, Hamming-Code für 1, 2 und 3 Fehler besteht, ausgewählt wird in Abhängigkeit von einer Ausfallwahrscheinlichkeit einer Speicherzelle, wie durch Testen der gefertigten Vorrichtungen auf Wafer bestimmt.

6. Nichtflüchtige Page-Modus-Speichervorrichtung nach Anspruch 1, wobei die Daten aus dem reservierten Bereich (RA) des Arrays in einem Single-Level-Modus gelesen werden.

7. Nichtflüchtige Page-Modus-Speichervorrichtung nach Anspruch 1, wobei mit Ausnahme von Boot-up-Programmcodes jeder beliebige andere vom Mikrocontroller auszuführende Programmcode in nichtflüchtiger Weise im reservierten Bereich (RA) des adressierbaren Bereichs des Arrays gespeichert ist, wobei die sich darin befindenden Programmcodes weiterhin bei jedem Einschalten der Vorrichtung in einen RAM-Puffer kopiert werden.

8. Verfahren zum Ersetzen von Ausfallarrayelementen einer nichtflüchtigen Page-Modus-Speichervorrichtung, die einen Array aus Zeilen und Spalten von Speicherzellen umfasst, der aufgeteilt ist in einen adressierbaren Bereich und einen Redundanzbereich, wobei das Verfahren **gekennzeichnet ist durch** die Schritte
Ermitteln, während einer Phase des Testens auf Wafer, einer Ausfallwahrscheinlichkeit einer gefertigten Zelle und von Arraybitleitungen;
Auswählen eines Fehlerkorrekturcodes zum Schreiben von Daten mit adäquater Fehlerkorrekturleistung für die festgestellten Ausfallwahrscheinlichkeiten;
Reservieren eines Bereichs (RA) des adressierbaren Bereichs des Speicherarrays, der **durch** den Benutzer der Speichervorrichtung nicht adressierbar ist, mit einer Speicherkapazität, die adäquat ist, um Ausfallspeicherortsdaten, wie während des Testens auf Wafer der gefertigten Vorrichtung ermittelt, zu speichern **durch** Schreiben der Ausfallspeicherortsdaten in denselben in Übereinstimmung mit dem ausgewählten Fehlerkorrekturcode;
Lesen und Decodieren der Ausfallspeicherortsdaten aus dem reservierten Bereich bei jedem Einschalten der Vorrichtung;
Kopieren der Ausfallblockdaten des reservierten Bereichs des Arrays in einen ersten flüchtigen Speicher (BAD BLOCK RAM) und von Ausfallbitleitungsdaten des adressierbaren Bereichs in einen zweiten flüchtigen Speicher (CALL.READ.CAM); und
Zugreifen auf den ersten flüchtigen Speicher und den zweiten flüchtigen Speicher zwecks Umleitens, zu Ersatzspeicherarrayelementen, jedes beliebigen externen Benutzerzugriffs auf die Ausfallspeicherorte.

9. Verfahren nach Anspruch 8, weiterhin umfassend:
Schreiben, mit dem ausgewählten Fehlerkorrekturcode, von Daten zur Selbstkonfiguration der Speichervorrichtung in den reservierten Bereich.

10. Verfahren nach Anspruch 8, wobei das Auswählen umfasst:
Auswählen des Fehlerkorrekturcodes aus der Gruppe, die aus Mehrheitscode 3, 5, 7, 15, Hamming-Code für 1, 2 und 3 Fehler besteht.

11. Verfahren nach Anspruch 8, wobei der erste flüchtige Speicher (BAD BLOCK RAM) als RAM-Puffer konfiguriert ist, der über eine Schnittstelle mit einem Mikrocontroller der Vorrichtung verbunden ist.

12. Verfahren nach Anspruch 8, wobei der zweite flüchtige Speicher (CALL.READ.CAM) als inhaltsadressierter Speicherarray konfiguriert ist, der angesprochen wird durch Spalten- und Zeilenadressen, erzeugt von einem Mikrocontroller der Vorrichtung.

13. Verfahren nach Anspruch 8, wobei das Lesen der Ausfallspeicherortsdaten auf einem Single-Level-Modus beruht.

## Revendications

1. Dispositif de mémoire non volatile à mode page comprenant une matrice de rangées et de colonnes de cellules de mémoire comportant une zone adressable et une zone de redondance, le dispositif comportant des moyens de circuit pour supporter des données d'emplacement de mémoire défaillante de ladite zone adressable à rediriger vers des éléments de remplacement de matrice de mémoire de ladite zone de redondance, **caractérisé en ce que** lesdits moyens de circuit comprennent :
au moins une zone réservée (RA), non adressable par l'utilisateur du dispositif, de ladite zone adressable de la matrice dans laquelle sont mémorisées lesdites données d'emplacement de mémoire défaillante selon une technique d'écriture de données protégée contre les erreurs conformément à un code de correction d'erreur choisi pour fournir une puissance adéquate de correction d'erreurs pour les probabilités de défaillance des cellules de mémoire et des lignes de bit de la matrice établies au cours d'une phase de test sur tranche ;
un circuit logique pour décoder les données d'emplacement de mémoire défaillante conformément au code de correction d'erreur utilisé lors de leur écriture ;
au moins une première mémoire non volatile (BAD BLOCK RAM) pour les blocs défaillants de ladite zone adressable et une seconde mémoire non volatile (CALL.READ.CAM) pour les lignes de bits de ladite zone adressable, dans lesquelles sont copiées les données d'emplacement de mémoire défaillante décodées, lues à partir de ladite zone réservée à la mise sous tension.

2. Dispositif de mémoire non volatile à mode page selon la revendication 1, dans lequel ladite première mémoire volatile (BAD BLOCK RAM) pour les blocs défaillants comprend une mémoire RAM tampon possédant une interface avec ledit microcontrôleur.

3. Dispositif de mémoire non volatile à mode page selon la revendication 1, dans lequel ladite seconde mémoire volatile (CALL.READ.CAM) pour les lignes de bits comprend une matrice CAM, stimulée par des adresses de colonnes et de rangées générées par ledit microcontrôleur, pour rediriger l'accès de l'utilisateur aux lignes de bit de remplacement de ladite zone de redondance.

4. Dispositif de mémoire non volatile à mode page selon la revendication 1, dans lequel sont également écrites, dans ladite zone réservée (RA) de la zone adressable de la matrice et selon la même technique d'écriture de données protégée contre les erreurs conformément audit code de correction d'erreur, des données d'auto-configuration du dispositif de mémoire utilisées dans l'exécution d'un code de programme d'auto-configuration exécuté par ledit microcontrôleur à chaque mise sous tension du dispositif, et le dispositif comprend une matrice à verrouillage dans laquelle lesdites données d'auto-configuration lues à partir de ladite zone réservée sont copiées à chaque mise sous tension du dispositif.

5. Dispositif de mémoire non volatile à mode page selon la revendication 1, dans lequel les données sont écrites sous un format de mots composés de seize bits et ledit code de correction d'erreur est choisi dans le groupe constitué par le code de majorité 3, 5, 7, 15, le code de Hamming pour 1, 2 et 3 erreurs, en fonction de la probabilité de défaillance d'une cellule de mémoire déterminée au cours d'un test sur tranche des dispositifs fabriqués.

6. Dispositif de mémoire non volatile à mode page selon la revendication 1, dans lequel lesdites données sont lues à partir de ladite zone réservée (RA) de la matrice dans un mode à niveau unique.

7. Dispositif de mémoire non volatile à mode page selon la revendication 1, dans lequel, à l'exception des codes de programme de démarrage, tout autre code de programme devant être exécuté par le microcontrôleur est mémorisé de manière non volatile dans ladite zone réservée (RA) de la zone adressable de la matrice, les codes de programme qui y résident étant également copiés dans une mémoire RAM tampon à chaque mise sous tension du dispositif.

8. Procédé visant à remplacer des éléments de matrice défaillants dans un dispositif de mémoire non volatile à mode page comprenant une matrice de rangées et de colonnes de cellules de mémoire divisée en une zone adressable et une zone de redondance, le procédé étant **caractérisé par** les étapes consistant à :
établir, au cour d'une phase de test sur tranche, une probabilité de défaillance d'une cellule fabriquée et de lignes de bit de la matrice ;
choisir un code de correction d'erreur pour écrire des données de puissance de correction d'erreurs adéquate pour les probabilités de défaillance estimées ;
réserver une zone (RA) de ladite zone adressable de la matrice de mémoire, non adressable par l'utilisateur du dispositif de mémoire, dont la capacité de mémorisation est adéquate pour mémoriser les données d'emplacement de mémoire défaillante qui ont été établies au cours dudit test sur tranche du dispositif fabriqué, en y écrivant les données d'emplacement de mémoire défaillante conformément audit code de correction d'erreur choisi ;
lire et décoder les données d'emplacement de mémoire défaillante à partir de ladite zone réservée à chaque mise sous tension du dispositif ;
copier les données de blocs défaillants de ladite zone réservée de la matrice dans la première mémoire volatile (BAD BLOCK RAM) et les données de ligne de bits défaillante de ladite zone adressable dans la seconde mémoire volatile (CALL.READ.CAM) ; et
accéder à ladite première mémoire volatile et à ladite seconde mémoire volatile afin de rediriger, vers les éléments de matrice de mémoire de remplacement, tout accès d'un utilisateur externe auxdits emplacements de mémoire défaillante.

9. Procédé selon la revendication 8, comprenant en outre :
l'écriture des données d'auto-configuration du dispositif de mémoire, en utilisant le code de correction d'erreur choisi, dans la zone réservée.

10. Procédé selon la revendication 8, dans lequel l'étape du choix comprend :
le choix du code de correction d'erreur dans le groupe constitué par le code de majorité 3, 5, 7, 15, le code de Hamming pour 1, 2 et 3 erreurs.

11. Procédé selon la revendication 8, dans lequel la première mémoire volatile (BAD BLOCK RAM) est configurée sous la forme d'une mémoire RAM tampon possédant une interface avec un microcontrôleur du dispositif.

12. Procédé selon la revendication 8, dans lequel la seconde mémoire volatile (CALL.READ.CAM) est configurée sous la forme d'une matrice de mémoire adressable par le contenu stimulée par des adresses de colonnes et de rangées générées par un microcontrôleur du dispositif.

13. Procédé selon la revendication 8, dans lequel ladite lecture des données d'emplacement de mémoire défaillante repose sur un mode à niveau unique.
